# EUROPEAN PATENT APPLICATION

(11) **EP 4 421 877 A1**
(43) Date of publication of application: **28.08.2024**
(21) Application number: 23158515.9
(22) Date of filing: 24.02.2023
(51) Int. Cl.: H01L 29/78, H01L 29/861, H01L 29/06

(54) **SEMICONDUCTOR DIE AND METHOD OF MANUFACTURING THE SAME**

(71) Applicant: Infineon Technologies Austria AG, 9500 Villach (AT)
(72) Inventor: WUTTE, Britta, 9181 Feistritz (AT); MARAK, Arnold, 9582 Latschach (AT); FEIL, Thomas Martin, 9523 Villach (AT)
(74) Representative: König Szynka Tilmann von Renesse Patentanwälte Partnerschaft mbB München

(57) **Abstract**

The disclosure relates to a semiconductor die (1) comprising a vertical transistor device (10) having a gate electrode (11) in a gate trench (12), and a MOS gated diode MGD (20) having an MGD gate electrode (21) in an MGD trench (22), wherein the gate trench (12) of the transistor device (10) has an elongated extension in a first lateral direction (31), and wherein the transistor device (10) and the MOS gated diode (20) are arranged consecutive in the first lateral direction (31).

## Description

### TECHNICAL FIELD

The present disclosure relates to a semiconductor die with a vertical transistor device.

### BACKGROUND

In a vertical transistor device, a vertical channel is formed laterally aside the gate region. For that purpose, the gate electrode is arranged in a gate trench extending vertically into the semiconductor body. Seen for instance in a vertical top view onto the die, the gate trench can have an elongated extension in a lateral direction.

### SUMMARY

It is an object of the present application to provide an advantageous semiconductor die and/or method of manufacturing the same.

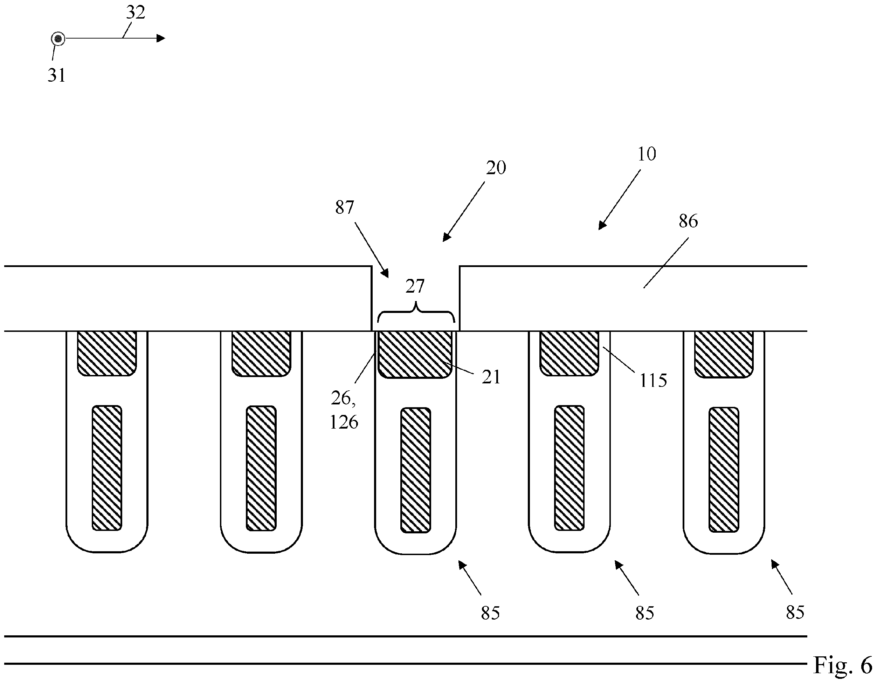

In the embodiment of claim 1, a MOS gated diode ("MGD") is formed in addition to the transistor device in the die. With respect to a first lateral direction, in which the gate trench of the transistor device has its elongated extension, the transistor device and the MGD are arranged consecutive. In comparison to an alternative arrangement, e. g. to placing the transistor and the MGD aside each other in a second lateral direction perpendicular to the first lateral direction (see figure 6 for illustration), the integration of an MGD placed aside the transistor device in the first lateral direction can for instance be less critical regarding lithography requirements.

For illustration, the transistor can for instance comprise a plurality of transistor device cells arranged consecutive in the second lateral direction, namely perpendicular to the elongated gate trenches. The gate trenches can particularly have a stripe-shape respectively, e. g. straight extension in the first lateral direction. The distance between the gate trenches in the second lateral direction can decrease with decreasing cell pitch. Consequently, arranging the transistor and the MGD aside each other in the second lateral direction, e. g. integrating the MGD between the device cells or gate trenches in the second lateral direction, could result in an increasing effort in lithography and manufacturing in general, see in detail below. Various embodiments and features are provided in this description and in the dependent claims. Therein, the individual features shall be disclosed independently of a specific claim category, the disclosure relates to apparatus and device aspects, but also to method and use aspects. If for instance a device manufactured in a specific way is described, this is also a disclosure of a specific manufacturing process, and vice versa.

In the first lateral direction, the gate trench has its elongated extension, this direction can also be referred to as "longitudinal direction". The lateral direction perpendicular thereto ("second lateral direction") can also be referred to as a transverse direction of the gate trench. Typically, at both lateral sides of the gate trench with respect to the transverse direction, a respective channel region can be arranged. Independently of these details, an approach of this application is to arrange the transistor device and the MGD consecutive with respect to the longitudinal direction of the gate trench. "Consecutive" shall not imply directly adjacent, e. g. not exclude another element in between the transistor device and the MGD, e. g. a contact structure (for instance a field electrode contact, see below).

The lateral direction(s) is or are for example perpendicular to a vertical direction of the die. The vertical direction can for instance lie perpendicular to a surface of a layer of the die, e. g. a surface of a silicon substrate and/or a surface of an epitaxial layer deposited onto the substrate and/or a surface of an insulating layer, on which a frontside metallization is deposited, and/or a surface of the frontside metallization itself.

The gate region of the transistor device can comprise the gate electrode and for instance a gate dielectric which capacitively couples the gate electrode to the channel region. Likewise, an MGD gate dielectric can couple the MGD gate electrode to the MGD channel region. The MGD gate dielectric can for instance have a smaller thickness than the gate dielectric of the transistor device, e. g. taken in the second lateral direction / transverse direction.

In particular, the term "MOS gated diode" or "MGD" can describe a MOSFET structure with a shorted gate electrode and source electrode, the MGD can for instance be considered as a two terminal field-effect structure. Further, the body region of the MGD, to which the MGD gate electrode capacitively couples and in which the MGD channel region is formed, can for instance be connected to the source contact of the die. Considering the transistor, a so-called body diode can for instance be formed between the body region of the vertical transistor device and its drain region or in particular drift region. The MGD can be connected in parallel to the body diode of the transistor device, which can for instance reduce switching or power losses.

In addition to the gate region with the gate electrode capacitively coupling to the body region / channel region, the transistor device can comprise a source region and a drain region. The source region can be arranged at a frontside of the semiconductor body and the drain region arranged at the vertically opposite backside thereof. From the frontside, the gate trench can extend vertically into the semiconductor body. In addition to the body region vertically between the source and the drain region, the transistor device can comprise a drift region vertically between the body region and the drain region, e. g. made of the same doping type but with a lower doping concentration compared to the drain region. The transistor device can in particular be a power device, e. g. have a breakdown voltage of at least 10 V, 20 V, 30 V, 40 V or 50 V, with possible upper limits of for instance not more than 800 V, 600 V, 400 V or 200 V (typical voltage classes can for instance be 60 V, 80 V, 100 V, 150 V and 200 V).

The transistor device and the MGD can in particular be of the same conductivity type, namely the body region of the transistor device of the same conductivity type as the MGD body region, e. g. of a second conductivity type. Analogously, the source regions of the transistor device and the MGD, as well as their drain regions, and drift regions, if present, can be of a first conductivity type. In the exemplary embodiments, the first conductivity type is n-type and the second conductivity type is p-type.

In general, though being arranged consecutive in the first lateral direction, the gate trenches or electrodes of the transistor device and the MGD can be displaced in the second lateral direction, e. g. up to half a cell pitch. In an embodiment, however, the gate electrode of the transistor device and the MGD gate electrode are arranged on a common straight line which lies parallel to the first lateral direction. Seen in a vertical top view, the common straight line, which is an imaginary line, can connect the transistor device, at least one cell thereof, and the MGD, again at least one cell thereof. Seen in a vertical top view, the imaginary common straight line can, with respect to the second lateral direction (transverse direction), in particular lie centrally in the gate trench and MGD trench. In other words, the gate trench and MGD gate trench are aligned in the first lateral direction.

In an embodiment, the gate electrode of the transistor device and the MGD gate electrode are arranged in the same trench, namely in different portions thereof. In other words, the gate electrode of the transistor device can be arranged in a first portion of the trench and the MGD gate electrode in a second portion of the same continuous trench, the first and second portion arranged consecutive in the first lateral direction. In other words again, the gate trench of the transistor device and the MGD trench are different portions of the same continuous trench which can particularly have a straight extension in the first lateral direction.

Generally, the transistor device can comprise a field electrode in a trench which for instance extends into the drift region. In addition to the field electrode, a respective field electrode region can comprise a field dielectric which can for example electrically isolate the field electrode from the drift region. The field electrode can for instance be electrically connected to the source region of the transistor device, e. g. via a frontside metallization. Independently of these details, the field electrode can for instance allow for a field shaping, e. g. in the drift region, by applying a voltage to the field electrode.

In a particular embodiment, the transistor device comprises a field electrode with an elongated shape, which can also be referred to as a field plate. In particular, the elongated field electrode can be arranged below the gate electrode in the gate trench. In other words, the field electrode is arranged in a lower portion of the gate trench and the gate electrode is arranged in an upper portion of the gate trench. In a particular embodiment, the field electrode is connected laterally between the transistor device and the MGD to a frontside contact, e. g. to the source contact of the die. The frontside contact can in particular be formed in a metallization layer, e. g. be a frontside metallization plate extending above the transistor device or in particular across a plurality of transistor device cells.

In an embodiment, a field electrode material of which the field electrode is made extends continuously in the common or continuous trench, in which the gate electrode of the transistor device and the MGD gate electrode are arranged. In other words, the field electrode material extends continuously in the first and in the second portion of the same continuous trench, and in case of a spacing between the first and second portion it extends also in between.

The MGD gate electrode can be connected to a frontside contact of the die, in particular to a source contact. In an embodiment, the MGD gate and electrode and the field electrode are connected to the same frontside contact, for instance to the same frontside metallization plate, see above. In other words, the field electrode and the MGD gate electrode are electrically connected to each other via the frontside contact. In use, they can be on the same electrical potential, e. g. source potential.

In an embodiment, the gate electrode of the transistor device and the MGD gate electrode arranged in the same continuous trench are made of the same gate electrode material, e. g. of the same metal or in particular polysilicon material. Generally, the gate electrode of the transistor device and the MGD gate electrode arranged in the same continuous trench are electrically isolated from each other, the gate electrode material being interrupted between the different portions of the trench. In an embodiment, the respective interruption portion, which is formed between the gate electrode of the transistor device and the MGD gate electrode, is used for electrically connecting the field electrode material arranged in the lower portion of the gate trench to the frontside contact.

In an embodiment, a body region of the transistor device and an MGD body region are different portions of a continuous implant region, e. g. made of a second conductivity type. Manufacturing wise, the transistor and the MGD body region can be made in the same process step, namely simultaneously. This can allow for a reuse of existing processing steps.

In an embodiment, a body region of the transistor device and an MGD body region are respectively connected via a vertical interconnect to a frontside contact of the die, in particular source contact (see above). In an embodiment, the same type of vertical interconnect can be used for the body region of the transistor device and the MGD body region, these interconnects can for instance be formed simultaneously in the same process step. They can for example be made of the same material and/or have the same dimensions, e. g. horizontally and/or vertically.

In an embodiment, a respective vertical transistor device is arranged on both sides of the MGD with respect to the first lateral direction. In other words, the MGD is arranged between a first and a second transistor device. Therein, a first gate electrode of the first transistor device can in particular be arranged in the same continuous trench like a second gate electrode of the second transistor device, the MGD gate electrode being for instance arranged laterally in between in the same continuous trench. The first and second transistor device can for example be connected in parallel, e. g. be different cells of the same transistor. For particular embodiments of the second transistor device, reference is made to the description above, any feature disclosed for the (first) transistor device can also be implemented to the second transistor device.

Generally, when reference to a "transistor device" is made, this can in particular be a respective transistor cell, wherein a plurality of transistor cells connected in parallel can form a common transistor. The transistor cells can have a translation symmetric arrangement with respect to the first lateral direction (see the paragraph above) and/or second lateral direction.

In an embodiment, a plurality of MGDs can be arranged aside each other, e. g seen in a vertical cross-section through the MGD, the cross-sectional plane lying for instance perpendicular to the first lateral direction. In other words, a plurality of MGDs can be arranged aside each other in the second lateral direction or transverse direction. Each MGD can comprise a respective MGD gate electrode in a respective MGD trench, a plurality of MGD trenches being arranged aside each other with respect to the second lateral direction. Therein, each MGD trench can for instance have an elongated and in particular straight extension in the first lateral direction. The MGDs can in particular be an MGD cell respectively, the MGD cells connected in parallel and for instance having a translation symmetric arrangement in the second lateral direction.

In an embodiment, at least ten MGDs are arranged aside each other, further lower limits being for instance at least 20, 30, 40, 50, 80 or 100 MGDs arranged side each other (upper limits can for example depend on the die size, exemplary numerical values can for instance be 100,000 or 10,000 MGDs). Independently of these details, any aspects disclosed for the (first) MGD above, can also be implemented to the other MGDs arranged aside each other in the second lateral direction. In particular, the MGDs arranged each other in the second lateral direction can be of the same type, e. g. have identical gate regions and/or body regions and/or source regions.

The application relates also to a method of manufacturing a semiconductor die, comprising the steps:
i) forming the vertical transistor device;
ii) forming the MGD.

Regarding further manufacturing details, reference is made to the description above. For instance, the body region of the transistor device and the MGD body region can be formed simultaneously, e. g. in the same implant step.

In an embodiment, forming the MGD comprises a removal of a first gate oxide from the MGD trench and a formation of a second gate oxide which can in particular be thinner than the first gate oxide. Referring to the ready-made die, the second gate oxide can in particular form the gate dielectric of the MGD gate region.

In an embodiment, an opening for the removal of the first gate oxide is defined by an etch mask, wherein this opening can particularly extend across a plurality of trenches in the second lateral direction. Independently of these details, an alignment of the etch mask or opening with respect to the trench or trenches can be simplified, e. g. in comparison to defining an opening laterally between two transistor cells with respect to the second lateral direction, see in detail above.

### BRIEF DESCRIPTION OF THE DRAWINGS

Below, the die and further details are explained by means of exemplary embodiments. Therein, the individual features can also be relevant for the application in a different combination.
- Figure 1: shows a cross-sectional view of a die comprising a vertical transistor device and a MOS gated diode;
- Figure 2: shows a sectional view through the transistor device, the sectional plane perpendicular to figure 1;
- Figure 3: shows a sectional view through the MOS gated diode, the sectional plane parallel to figure 2;
- Figure 4: shows a sectional view through a body region of the transistor device and an MGD body region, the sectional plane parallel to figure 1;
- Figure 5: shows a sectional view of vertical contacts of the body region of the transistor device and of the MGD body region, the sectional plane parallel to figures 1 and 4;
- Figure 6: illustrates a manufacturing step for an alternative arrangement of a transistor device and a MOS gated diode;
- Figure 7: illustrates the wiring of a transistor device and a MOS gated diode in a circuit diagram;
- Figure 8: summarizes some manufacturing steps in a flow diagram.

### DETAILED DESCRIPTION

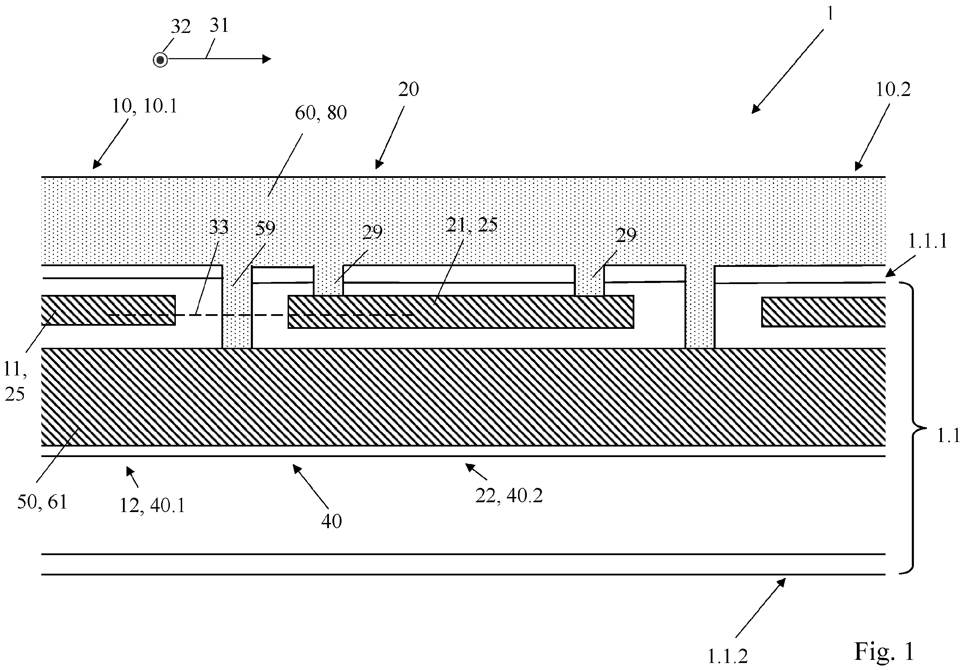

Figure 1 shows a die 1 in which a vertical transistor device 10 and a MOS gated diode MGD 20 are formed. The transistor device 10 comprises a gate electrode 11 arranged in a gate trench 12 and the MGD 20 comprises an MGD gate electrode 21 in an MGD trench 22. The gate trench of the transistor device 10 has an elongated extension in a first lateral direction 31 which lies parallel to the sectional plane of figure 1 (and perpendicular to a second lateral direction 32). The transistor device 10 and the MGD 20 are arranged consecutive in the first lateral direction 31. In detail, the gate electrode 11 of the transistor device 10 and the MGD gate electrode 21 are arranged on a common straight line 33 lying parallel to the first lateral direction 31.

Further, the gate electrode 11 and the MGD gate electrode 21 are arranged in the same continuous trench 40. The trench 40 is etched into a semiconductor body 1.1 of the die 1 namely extends from a frontside 1.1. 1 vertically into the semiconductor body 1.1 (the numeral 1.1.2 references the backside). The trench 40 has an elongated extension in the first lateral direction 31. The gate trench 12 with the gate electrode 11 is a first portion 40.1 of the continuous trench 40 and the MGD trench 22 is a second portion 40.2 thereof.

The transistor device 10 comprises a field electrode 50 which is arranged vertically below the gate electrode 11 in the gate trench 12. It is made of a field electrode material 61, e. g. doped polysilicon. The field electrode material 61 extends in the first lateral direction 31 continuously in the continuous trench 40, e. g. also below the MGD gate electrode 21 and in between the transistor device 10 and the MGD 20. There, a field electrode interconnect 59 is formed, e. g. made of metal, and electrically connects the field electrode 50 to a frontside contact 60, in the example shown to a source metallization plate 80.

The MGD gate electrode 21 is also connected to the frontside contact 60, namely via MGD interconnects 29. These can for instance be made of metal as well. The interconnects 29, 59 can be made in separate process steps or can be formed simultaneously. In particular, they can be formed in the course of the metal deposition of the metallization plate 80. The gate electrode 11 and the MGD gate electrode 21 are made of the same gate electrode material 25, e. g. doped polysilicon, which is interrupted between the transistor device 10 and the MGD 20.

In the example shown, a second transistor device 10.2 is arranged at the other side of the MGD 20. With respect to the first lateral direction 31, the MGD 20 is embedded between a first transistor device 10.1 and second transistor device 10.2. In this example, the second transistor device 10.2 is identical in construction to the first transistor device 10.1, and they are connected in parallel.

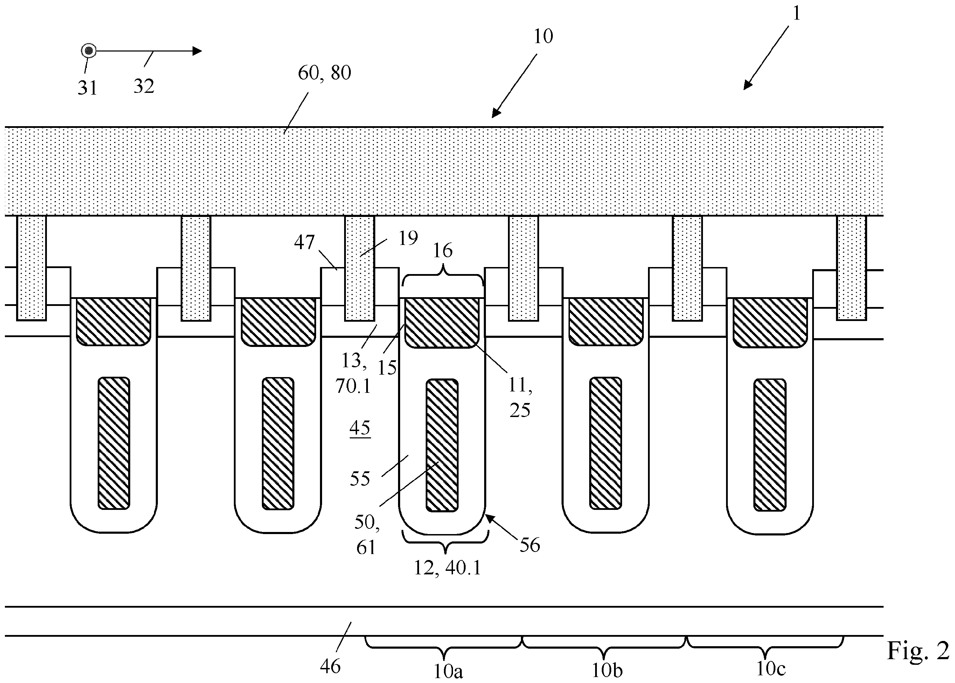

Figure 2 shows another sectional view of the die 1, wherein the sectional plane lies perpendicular to the first lateral direction 31, namely parallel to the second lateral direction 32. Generally, in this disclosure, the like reference numerals indicate the like elements or elements having the like function and reference is always made to the description of the other figures as well. Figure 2 illustrates the field electrode 50 arranged below the gate electrode 11 in the gate trench 12. Together with a gate dielectric 15, the gate electrode 11 forms a gate region 16, the gate dielectric 15 capacitively coupling the gate electrode 11 to the body region 13. A field dielectric 55 capacitively couples the field electrode 50 to a drift region 45. The field electrode 50 and the field dielectric 55 form a field electrode region 56.

Below the drift region 45 a drain region 46 is arranged, which is of the same doping type like a source region 47 arranged above the body region 13. The source region 47, drift region 45 and drain region 46 are of a first conductivity type and the body region 13 is of a second conductivity type. The source region 47 and body region 13 are connected to the frontside contact 60 via a vertical interconnect 19, e. g. made of metal. In the example shown, a plurality of transistor devices 10, or, in other words, a plurality of transistor device cells 10a-c are arranged aside each other in the second lateral direction 32.

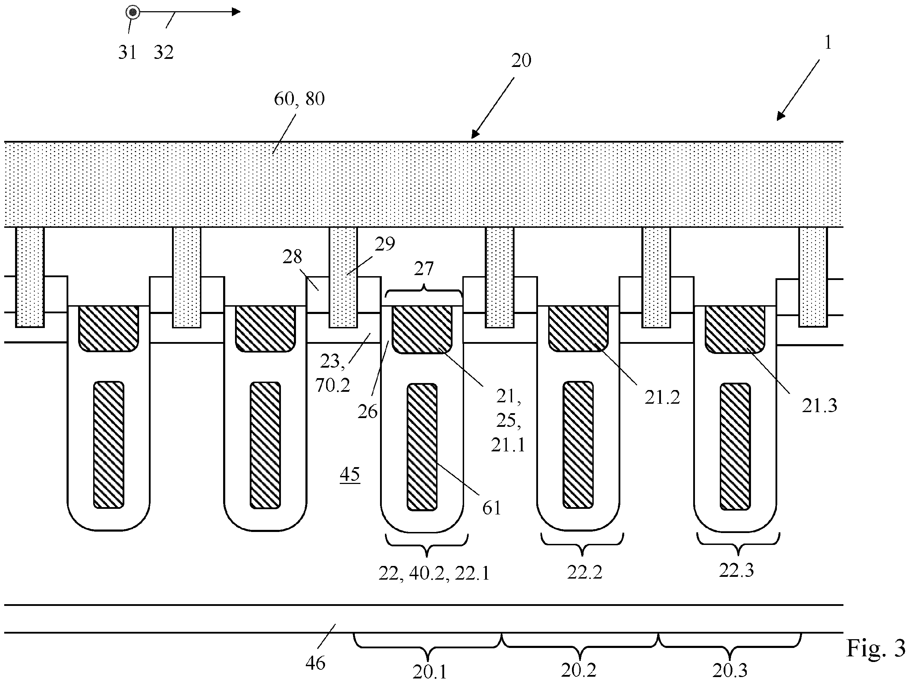

Figure 3 shows another cross-section through the die 1, namely through the MGD 20. Again, the sectional plane lies parallel to the second lateral direction 32. Below the MGD gate electrode 21, the field electrode material 61 extends in the MGD trench 22. Together with an MGD gate dielectric 26, the MGD gate electrode 21 forms an MGD gate region 27. The MGD gate dielectric 26 capacitively couples the MGD gate electrode 21 to the MGD body region 23. The MGD gate dielectric 26 is thinner compared to the gate dielectric 15 of the transistor device 10.

Below the MGD body region 23, the drift region 45 and the drain region 46 are arranged. Above, an MGD source region 28 is arranged. The MGD body region 23 and source region 28 are shorted via the MGD interconnect 29. In this example, the MGD source and body region 28, 23, as well as the drift region 45 and the drain region 46, are respectively made of the same doping type and concentration like the respective region of the transistor device 10, namely its source and body region 47, 13 and drift and drain region 45, 46. The MGD source and body region 28, 23 are connected to the frontside contact 60 via an MGD vertical interconnect 29, e. g. made of metal.

In the second lateral direction 32, a plurality MOS gated diodes 20.1-20.3 are arranged aside each other, each comprising a respective MGD gate electrode 21.1-21.3 in a respective MGD trench 22.1-22.3.

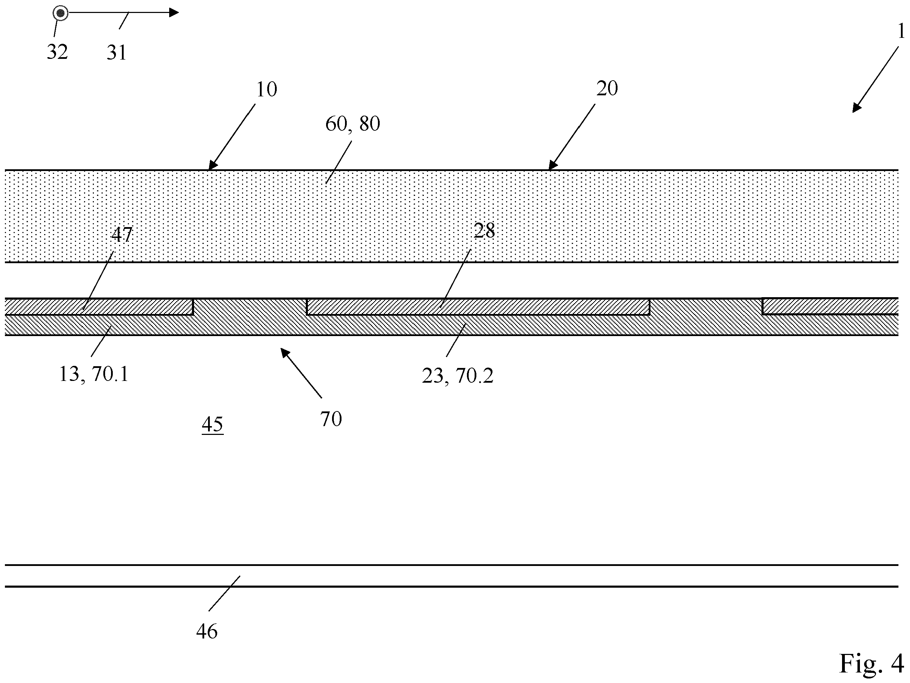

Figure 4 shows a sectional view, wherein the sectional plane lies parallel to the first lateral direction 31. Referring to figures 2 and 3, the sectional plane of figure 4 lies laterally between the interconnects 19, 29 and the gate regions 16, 27. The body region 13 of the transistor device 10 and the MGD body region 23 of the MGD 20 are part of the same continuous implant region 70. The body region 13 is a first portion 70.1 and the MGD body region 23 is a second portion 70.2 of the implant region 70. Above the body region 13 the source region 47 of the transistor device 10 is arranged and the MGD source region 28 is arranged above the MGD body region 23.

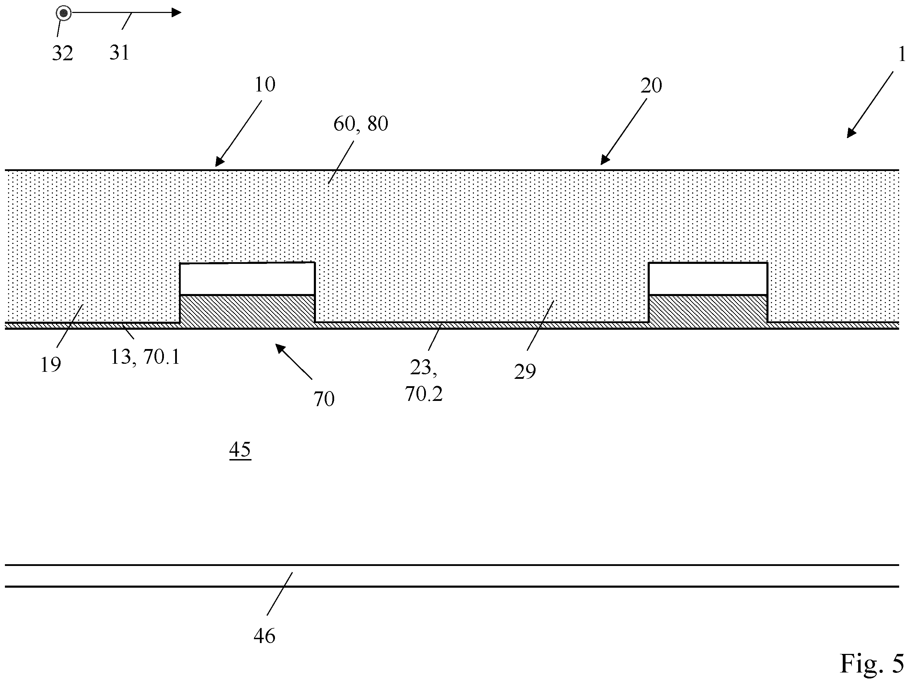

Figure 5 shows another sectional view, wherein the sectional plane lies parallel to the first lateral direction 31. With reference to figures 2 and 3, the sectional plane is arranged in between two device cells or MGDs, it intersects the vertical interconnect 19 of the transistor device 10 and the MGD vertical interconnect 29 of the MGD 20. The vertical interconnect 19 connects the source region (not visible here) and the body region 13 of the transistor device to the frontside contact 60. The MGD vertical interconnect 29 connects the MGD source region (not visible here) and the MGD body region 23 to the frontside contact 60.

Figure 6 illustrates a manufacturing step for a set-up in which an MGD 20 and a transistor device would not be arranged consecutive in the first lateral direction 31. Instead, for the purpose of illustration, they are arranged aside each other in the second lateral direction 32 which lies perpendicular to the length extension of the trenches 85. To fabricate the MGD gate region 27, a mask 86 has been deposited, wherein an opening 87 of the mask 86 has to be aligned with the upper end of the trench 85. Then, a first gate oxide 115, which forms the gate dielectric 15 of the transistor device later on, can be removed, and a second gate oxide 126 can be deposited.

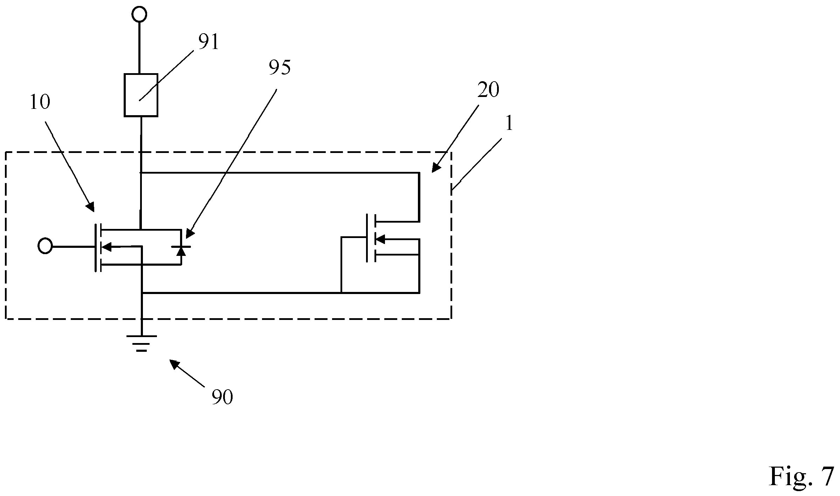

Figure 7 illustrates the transistor device 10 and the MGD 20 in a circuit diagram. In the example shown, the transistor device 10 is an n-channel MOSFET connected in a low side configuration. Its source contact is connected to ground 90 and its drain contact is connected to a load 91. The body diode of the transistor device 10 is referenced with the numeral 95. The MGD 20 is connected in parallel to the transistor device 10, wherein the gate is shorted to the source contact.

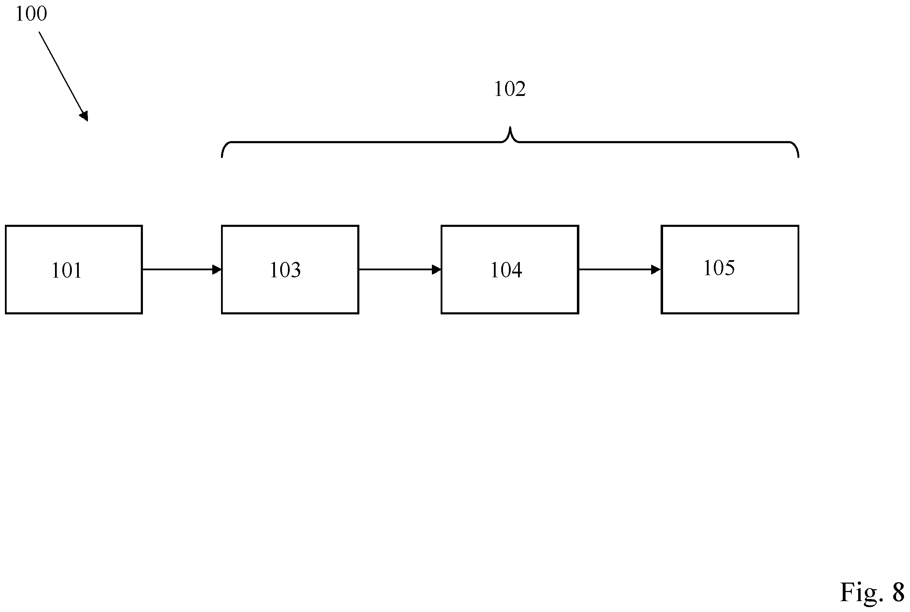

Figure 8 summarizes some manufacturing steps 100 in a flow diagram. Though the forming 101 of the transistor device and the forming 102 of the MGD are shown as subsequent steps, they can also occur simultaneously, at least partly. For forming 102 the MGD, an etch mask can be provided 103, defining an opening, e. g. across a plurality of trenches. Then, a first gate oxide can be removed 104 and a second gate oxide can be formed 105.

## Claims

1. A semiconductor die (1) comprising
a vertical transistor device (10) having a gate electrode (11) in a gate trench (12), and
a MOS gated diode MGD (20) having an MGD gate electrode (21) in an MGD trench (22),
wherein the gate trench (12) of the transistor device (10) has an elongated extension in a first lateral direction (31),
and wherein the transistor device (10) and the MOS gated diode (20) are arranged consecutive in the first lateral direction (31).

2. Semiconductor die (1) of claim 1, wherein the gate electrode (11) of the transistor device (10) and the MGD gate electrode (21) are arranged on a common straight line (33) which lies parallel to the first lateral direction (31).

3. Semiconductor die (1) of claim 1 or 2, wherein the gate electrode (11) of the transistor device (10) and the MGD gate electrode (21) are arranged in different portions (40.1, 40.2) of a continuous trench (40).

4. The semiconductor die (1) of any one of the preceding claims, the transistor device (10) comprising an elongated field electrode (50) in the gate trench (12) below the gate electrode (11), wherein the field electrode (50) is connected laterally between the transistor device (10) and the MOS gated diode (20) to a frontside contact (60).

5. The semiconductor die (1) of claims 3 and 4, wherein the field electrode (50) is made of a field electrode material (61), the field electrode material (61) extending continuously in the continuous trench (40), namely in the gate trench (12) and in the MGD trench (22).

6. The semiconductor die (1) of claim 4 or 5, wherein also the MGD gate electrode (21) is connected to the frontside contact (60).

7. The semiconductor die (1) of claim 3 in combination with one of claims 4 to 6, wherein the gate electrode (11) of the transistor device (10) and the MGD gate electrode (21) are made of the same gate electrode material (25), the gate electrode material (25) arranged in the continuous trench (40) and interrupted between the different portions (40.1, 40.2) of the continuous trench (40).

8. The semiconductor die (1) of any one of the preceding claims, wherein a body region (13) of the transistor device (10) and an MGD body region (23) of the MOS gated diode (20) are different portions (70.1, 70.2) of a continuous implant region (70).

9. The semiconductor die (1) of any one of the preceding claims, wherein a body region (13) of the transistor device (10) is connected to a frontside contact (60) by a vertical interconnect (19), and an MGD body region (23) of the MOS gated diode (20) is connected to the frontside contact (60) by an MGD vertical interconnect (29) which is of the same type like the vertical interconnect (19) of the transistor device (10).

10. The semiconductor die (1) of any one of the preceding claims, wherein a respective vertical transistor device (10.1, 10.2) is arranged on both sides of the MOS gated diode (20) with respect to the first lateral direction (31).

11. The semiconductor die (1) of any one of the preceding claims, wherein, seen in a vertical cross-section perpendicular to the first lateral direction (31) through the MOS gated diode (20), a plurality of MOS gated diodes (20.1-20.3) with a respective MGD gate electrode (21.1-21.3) in a respective MGD trench (22.1-22.3) are arranged aside each other.

12. The semiconductor die (1) of claim 11, wherein, seen in the vertical cross-section, at least ten MOS gated diodes (20.1-20.3) are arranged aside each other.

13. A method of manufacturing the semiconductor die (1) of any one of the preceding claims, comprising the steps:
i) forming (101) the vertical transistor device (10);
ii) forming (102) the MOS gated diode (20).

14. The method of claim 13, wherein step ii) comprises:
- removing (104) a first gate oxide (115) from the MGD trench (22),
- forming (105) a second gate oxide, which is thinner than the first gate oxide, in the MGD trench (22).

15. The method of claim 14, wherein an etch mask defines an opening for the removing of the first gate oxide, the opening extending across a plurality of trenches in a second lateral direction perpendicular to the first lateral direction (31).
